# EUROPEAN PATENT APPLICATION

(11) **EP 4 748 887 A1**
(43) Date of publication of application: **27.05.2026**
(21) Application number: 25213334.3
(22) Date of filing: 04.11.2025
(51) Int. Cl.: C08L 63/00

(54) **COMPOSITION FOR UNDERFILL AND METHOD FOR MANUFACTURING THE SAME**

(30) Priority: 22.11.2024 KR 20240168103; 24.07.2025 KR 20250100784
(71) Applicant: Korea Advanced Institute of Science and Technology, Daejeon 34141 (KR)
(72) Inventor: KIM, Seong Su, 34141 Daejeon (KR); LEE, Mingeun, 34141 Daejeon (KR); CHO, Donghyeon, 34141 Daejeon (KR); LEE, Jeeeun, 34141 Daejeon (KR); BAE, Sangyoon, 34141 Daejeon (KR); JO, Jaeyoung, 34141 Daejeon (KR); LEE, Seondo, 34141 Daejeon (KR); LEE, Ha Eun, 34141 Daejeon (KR); KIM, Wonki, 34141 Daejeon (KR)
(74) Representative: Manitz Finsterwald Patent- und Rechtsanwaltspartnerschaft mbB

(57) **Abstract**

The present disclosure relates to a composition for underfill and a method for manufacturing the same, in which spherically and temporarily fixed high-thermal-conductivity shape-memory polymer composite particles are applied to the underfill, maintaining low viscosity during the filling process, and, at curing temperature, the particles are restored to a high aspect ratio shape to form a thermally conductive network between ceramics, thereby simultaneously achieving low filling viscosity and high heat dissipation performance.

## Description

### BACKGROUND OF THE INVENTION

### (a) Field of the Invention

The present disclosure relates to a composition for underfill and a method for manufacturing the same.

### (b) Description of the Related Art

In the semiconductor packaging process, the space between the chip and the substrate is filled with an epoxy-based underfill to mechanically and chemically protect the solder balls or solder bumps that serve as electrical connections. During the filling stage, underfill requires low viscosity for capillary flow, but at the same time, high thermal conductivity is necessary to effectively dissipate heat generated during the operation of the semiconductor package. Increasing the amount of thermally conductive ceramic fillers to achieve this raises thermal conductivity; however, there is a conflicting issue in that viscosity increases sharply due to the increased surface area and interparticle interference. In particular, high aspect ratio particles such as rods and plates are advantageous for forming thermal conduction pathways, but their increased viscosity significantly impairs the processability of filling. Therefore, various studies are underway to develop underfills that simultaneously satisfy low viscosity and high thermal conductivity.

To resolve the trade-off issue between viscosity and thermal conductivity, the present disclosure provides a composition for underfill that imparts high thermal conductivity to shape memory polymer particles, satisfying low viscosity by fixing the filler in a spherical particle, and satisfying excellent thermal conductivity by restoring the particles to a high aspect ratio shape through heat applied in the underfill curing process.

Meanwhile, research to develop high-thermal conductivity heat-dissipating materials by chemically or physically attaching ceramic fillers to the surfaces of thermoplastic or thermosetting polymer particles have been reported. For example, Republic of Korea Patent No. 10-1493781 proposes a thermally conductive ceramic-polymer composite that constructs a thermal conduction pathway by aligning ceramic plate-like fragments at the interface of thermoplastic polymer spherical particles, and Republic of Korea Patent No. 10-1993272 proposes a heat-dissipating composite in which polyamide and h-BN filler are physically and chemically bonded through mechanofusion and plasma treatment. However, the above heat-dissipating materials are premised on applications that may be used with relatively high viscosity, such as injection-molded products, sheets, and films; thus, it is not applicable to low-viscosity material that require capillary filling steps, such as semiconductor underfill processes.

In addition, Republic of Korea Patent No. 10-2384105 proposes ceramic-polymer composite particles that simultaneously provide electrical insulation and thermal conductivity by attaching plate-shaped boron nitride, which has been micronized and exfoliated, to the surface of spherical polymethyl methacrylate particles via electrostatic or van der Waals forces. Republic of Korea Patent No. 10-1310072 proposes a method for manufacturing a heat-dissipating composite by dispersing composite particles, in which an inorganic coating layer and a thermally conductive material are formed on the surface of a filler, in a polymer matrix. However, both technologies do not introduce a shape memory function into the composite particles, so even if the ceramic-polymer composite particles are used as reinforcing agents in composition for underfills, there is a fundamental limitation in that the trade-off issue between viscosity and thermal conductivity cannot be resolved.

In addition, Chinese Patent No. 111454468 presents a manufacturing method for cellulose acetate-based shape memory polymer spherical particles with a size of several micrometers to memorize and restore their shape through a stretching-cooling process. However, it proposes a method of temporarily fixing them in a high aspect ratio shape, which cannot be applied for achieving low-viscosity underfill implementation, and since it does not include thermally conductive ceramics, there are limitations in securing heat dissipation performance.

### SUMMARY OF THE INVENTION

According to one embodiment of the present disclosure, a composition for underfill that maintains low viscosity during the underfill filling process and achieves high thermal conductivity after the underfill curing process is provided.

According to another embodiment of the present disclosure, a method for manufacturing the composition for underfill is provided.

### BRIEF DESCRIPTION OF THE DRAWINGS

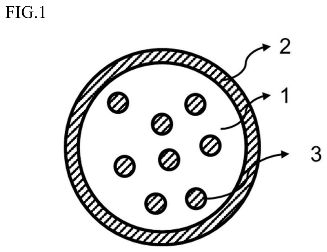

FIG. 1 is a cross-sectional schematic diagram of a shape memory polymer composite particle in which ceramic powder is either dispersed inside (3) a spherical shape memory polymer particle (1) , or ceramic powder is coated on the outer surface (2) of the spherical shape memory polymer particle (1).
FIG. 2 is a schematic diagram sequentially showing the entire process comprising the steps of: dispersing the shape memory polymer composite particle precursor in an water-soluble polymer solution and drying to produce a water-soluble polymer film; heating the water-soluble polymer film to produce shape memory polymer composite particles; and dissolving the water-soluble polymer film in water to recover the shape memory polymer composite particles from the water-soluble polymer film.

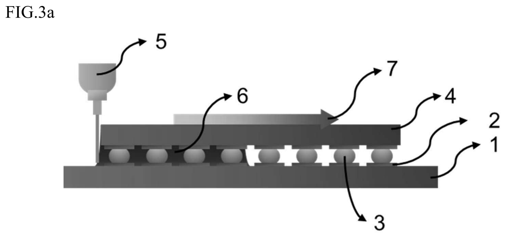

FIG. 3a is a schematic diagram showing a chip (4), a packaging substrate (1), copper pads (2), and solder balls or solder bumps (3). It is a schematic showing the process of capillary filling (7) between the semiconductor chip (4) and the packaging substrate (1) with an composition for underfill (6) according to one embodiment of the present disclosure using an underfill dispenser (5).

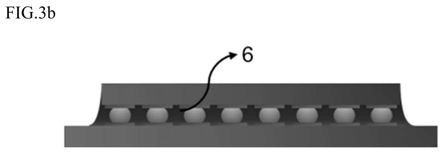

FIG. 3b is a schematic diagram showing the process in which, after curing the assembly of FIG. 3a, the shape memory polymer composite particles (6) are restored to a high aspect ratio shape while the composition for underfill is cured.

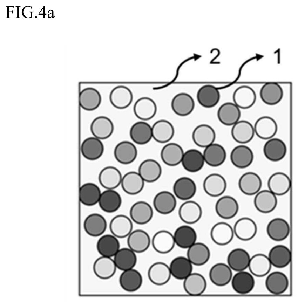

FIG. 4a is a schematic diagram showing the state in which the shape memory polymer composite particles (1), temporarily fixed in a spherical shape, are uniformly dispersed in the composition for underfill (2).

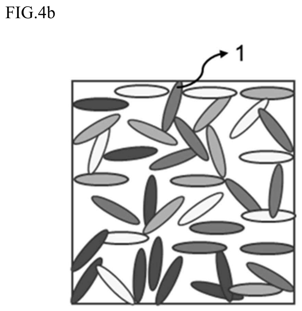

FIG. 4b is a schematic diagram showing the structure in which, while the underfill of FIG. 4a is cured, the shape memory polymer composite particles (1) are restored to a high aspect ratio shape to form a continuous network between ceramics.

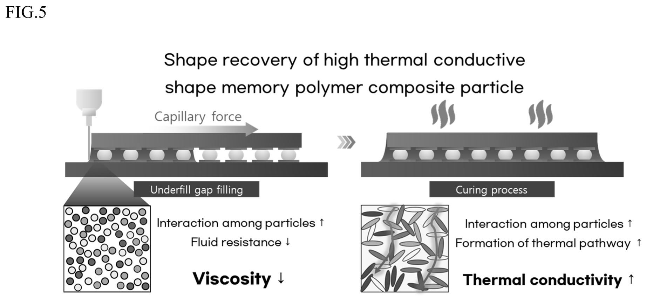

FIG. 5 is a schematic diagram showing the mechanism that occurs during the filling and curing process of the composition for underfill.
FIG. 6 is a schematic diagram showing the process of surface functionalizing polymethyl methacrylate particles with 3-glycidyloxypropyltrimethoxysilane in Preparation Example 1.
FIG. 7 is a schematic diagram showing the step of heat treating at 1000°C for 2 hours in a tube furnace under an air atmosphere, in order to improve the interfacial bonding force between the surface-functionalized polymethyl methacrylate particles and boron nitride particles in Preparation Example 1.
FIG. 8 is a graph showing the Fourier-transform infrared spectroscopy analysis results of heat-treated boron nitride and non-heat-treated boron nitride in Preparation Example 1. It may confirm that an absorption peak appears near 3216 cm⁻¹ in the heat-treated boron nitride.
FIG. 9 is an image observed with a scanning electron microscope of a sample in Preparation Example 1, in which boron nitride particles functionalized with hydroxyl groups are coated on the outer surface of surface-treated polymethyl methacrylate particles.
FIG. 10 is a schematic diagram showing the process of coating mechanically boron nitride particles onto the outer surface of cellulose acetate particles using a mechanofusion device at 5000 rpm for 5 hours in Preparation Example 2
FIG. 11 is an image observed with a scanning electron microscope of a sample in Preparation Example 2, in which boron nitride particles are coated on the outer surface of cellulose acetate particles through the mechanofusion process.
FIG. 12 is a schematic diagram showing the process of forming a heat transfer path (3) along the ceramic on the outer surface of the shape memory polymer composite particles by dispersing shape memory polymer composite particles (2) in the composition for underfill (1) in Experimental Example 1.
FIG. 13 is an image observed with a scanning electron microscope of a cured sample of the composition for underfill in Experimental Example 1. It may confirm spherical shape memory polymer particles (1), boron nitride particles (2) on their outer surfaces, and the cured resin matrix (3) inside the cured sample.
FIG. 14 is an image observed with a scanning electron microscope in two dimensions of the exposed cross-section of a cured and polished sample of the composition for underfill in Experimental Example 1, showing boron nitride particles (1) surrounding the cellulose acetate particles (2) and resin matrix (3).
FIG. 15 is a graph comparing the thermal conductivity according to the weight ratio of boron nitride to the total weight of the composition for underfill of Examples 5-8 and Comparative Examples 1-4 in Experimental Example 1.
FIG. 16 is a graph comparing the viscosity according to the weight ratio of boron nitride to the total weight of the composition for underfill of Examples 5-8 and Comparative Examples 1-4 in Experimental Example 1.

### DETAILED DESCRIPTION OF THE EMBODIMENTS

According to one embodiment of the present disclosure, there is provided a composition for underfill comprising a thermosetting resin, a curing agent, and a shape memory polymer composite particle, wherein the shape memory polymer composite particle comprise a spherical shape memory polymer particle and ceramic powder bonded to the spherical shape memory polymer particle.

According to another embodiment of the present disclosure, there is provided a method for manufacturing a composition for underfill, comprising the steps of: manufacturing a shape memory polymer composite particle; mixing and stirring a thermosetting resin, a curing agent, and the shape memory polymer composite particle; wherein the shape memory polymer composite particle comprise a spherical shape memory polymer particle and ceramic powder bonded to the spherical shape memory polymer particle.

Hereinafter, the composition for underfill and the method for manufacturing the composition for underfill according to specific embodiments of the present disclosure will be explained in detail.

Unless otherwise specified in the present disclosure, the terms "comprise" or "include" refer to including certain components (or elements) without particular limitation, and may not be interpreted as excluding the addition of other components (or elements).

In the present disclosure, terms such as first, second, and so on are used to describe various components, and these terms are used solely for distinguishing one component from another.

Additionally, unless the steps constituting the manufacturing method described herein are explicitly stated to be sequential or continuous, or there is another special order, the order in which one step of a manufacturing method is described in the present disclosure is not limited to the order described in the present disclosure. Accordingly, the order of the steps constituting the manufacturing method may be varied within a range readily understandable to those skilled in the art, and in such cases, any subsequent changes apparent to those skilled in the art are within the scope of the present disclosure.

According to one embodiment of the present disclosure, there is provided a composition for underfill comprising a thermosetting resin, a curing agent, and a shape memory polymer composite particle, wherein the shape memory polymer composite particle comprise a spherical shape memory polymer particle and ceramic powder bonded to the spherical shape memory polymer particle.

The inventors have found that, since the composition for underfill comprises the shape memory polymer composite particle, while maintaining a low viscosity suitable for use in the filling step of the underfill process, it is possible to achieve high thermal conductivity by forming a continuous thermal conductive network between particles after curing is completed, thereby improving the heat generation problem of a semiconductor package. Furthermore, the composition of the above embodiment is experimentally confirmed to be applicable to thermosetting heat dissipation material systems that simultaneously require low viscosity and high thermal conductivity, thereby completing the present invention.

The composition for underfill of this embodiment may be a composition for underfill prepared by the manufacturing method of the composition for underfill according to another embodiment described below.

The composition for underfill according to one embodiment of the present disclosure may include a thermosetting resin, a curing agent, and a shape memory polymer composite particle.

The shape memory polymer composite particles may refer to a particle manufactured using shape memory polymers.

In the present disclosure, the shape memory polymers may refer to polymers that exhibit characteristics of easily returning from a temporary shape to a permanent shape in response to external stimuli such as heat, light, electricity, magnetic field, pH, enzymes, and ions.

The shape memory polymer may be fixed in a temporary shape when cooled in a deformed state above the glass transition temperature (Tg) due to a temperature increase, and has the property of being restored from the temporary shape to the permanent shape when reheated above the glass transition temperature.

For example, the shape memory polymer may be deformed into a temporary shape by an external force as the polymer chains become more mobile and the chain arrangement becomes freer upon reaching the glass transition temperature during heating, and may be fixed in the temporary shape as the mobility of the polymer chains decreases during cooling. When the shape memory polymer fixed in the temporary shape is reheated to reach above the glass transition temperature, the chains regain mobility due to the temperature increase, and the fixed temporary shape returns to the permanent shape due to the tendency to return to a state of minimum energy.

The shape memory polymer may include one or more shape memory polymers selected from the group consisting of polyacrylate, cellulose-based resin, polycaprolactone, polyurethane, polyimide, polyvinyl alcohol, polyimide, epoxy resin, polyolefin, polystyrene, and polycarbonate. Preferably, the shape memory polymer may include one or more shape memory polymers selected from the group consisting of polycaprolactone, polyacrylate, or cellulose-based resin, and more specifically, may include one or more shape memory polymers selected from the group consisting of polycaprolactone, polymethyl methacrylate, or cellulose acetate.

The shape memory polymer composite particle may include spherical shape memory polymer particle and ceramic powder bonded to the spherical shape memory polymer particle. That is, the shape memory polymer composite particle may refer to a composite material in which the reinforcing material, ceramic powder, is bonded to the spherical shape memory polymer particle.

As the shape memory polymer composite particle include ceramic powder bonded to the spherical shape memory polymer particle, the thermal conductivity of the composite particle itself may be increased by forming a thermal pathway along the ceramic powder coated on the outer surface of the spherical shape memory polymer particle or including the ceramic powder inside the spherical shape memory polymer particle in the composition for underfill according to one embodiment of the present disclosure

In addition, the composition for underfill may maintain a low viscosity as the shape memory polymer composite particle exist in a spherical form prior to the curing of the composition for underfill due to the shape recovery property. At the same time, when the composition for underfill is cured, the increase in temperature causes the shape memory polymer composite particle to recover permanent shape with a high aspect ratio, forming a thermal conductivity network within the composition for underfill and thereby achieving excellent heat dissipation characteristics.

The spherical shape memory polymer particle may have an average particle diameter of 0.1 µm or more and 50 µm or less. Specifically, the spherical shape memory polymer particle may have an average particle diameter of 0.1 µm or more, 1 µm or more, 5 µm or more, 7 µm or more, 50 µm or less, 30 µm or less, 20 µm or less, 10 µm or less, or 0.1 µm or more and 50 µm or less, 1 µm or more and 50 µm or less, 5 µm or more and 50 µm or less, 7 µm or more and 50 µm or less, 0.1 µm or more and 30 µm or less, 1 µm or more and 30 µm or less, 5 µm or more and 30 µm or less, 7 µm or more and 30 µm or less, 0.1 µm or more and 20 µm or less, 1 µm or more and 20 µm or less, 5 µm or more and 20 µm or less, 7 µm or more and 20 µm or less, 0.1 µm or more and 10 µm or less, 1 µm or more and 10 µm or less, 5 µm or more and 10 µm or less, or 7 µm or more and 10 µm or less.

The average particle diameter may refer to D50. The D50 may refer to the particle diameter at which, among the particle size distributions measured using a laser diffraction scattering particle size analyzer, 50% of the total mass is accumulated from the smaller side. The D50 may be measured, for example, by the laser diffraction method. The laser diffraction method generally enables the measurement of particle diameters ranging from the submicron region to several millimeters, and it is possible to obtain results with high reproducibility and high resolution.

If the average particle diameter of the spherical shape memory polymer particle becomes excessively small, surface interactions such as van der Waals interactions increase, resulting in aggregation among the spherical shape memory polymer particles, which may lead to an increase in the viscosity of the composition for underfill. Additionally, as the interface through which heat must pass during thermal conduction increases, interfacial thermal resistance may occur, which may lead to reducing thermal conductivity. If the average particle diameter of the spherical shape memory polymer particles becomes excessively large, due to the height between the chip and substrate on the micro scale, the spacing of solder balls, and the spacing between solder bumps, it may be unsuitable for application to the composition for underfill.

The ceramic powder may include one or more compounds selected from the group consisting of AlN, h-BN, Al₂O₃, and SiO₂. Preferably, the ceramic powder may include h-BN.

The ceramic powder may have an average particle diameter of 0.1 µm or more and 10 µm or less. Specifically, the ceramic powder may have an average particle diameter of 0.1 µm or more, 1 µm or more, 10 µm or less, 5 µm or less, or 0.1 µm or more and 10 µm or less, 1 µm or more and 10 µm or less, 0.1 µm or more and 5 µm or less, or 1 µm or more and 5 µm or less.

The average particle diameter may refer to D50. The D50 may refer to the particle diameter at which, among the particle size distributions measured using a laser diffraction scattering particle size analyzer, 50% of the total mass is accumulated from the smaller side. The D50 may be measured, for example, by the laser diffraction method. The laser diffraction method generally enables the measurement of particle diameters ranging from the submicron region to several millimeters, and it is possible to obtain results with high reproducibility and high resolution.

If the average particle diameter of the ceramic powder becomes excessively small, not only does the processability of manufacturing shape memory polymer composite particle deteriorate due to agglomeration between particles, but also the interfacial thermal resistance increases, which may lead to a decrease in thermal conductivity. If the average particle diameter of the ceramic powder becomes excessively large, it may be difficult for the ceramic powder to be coated on the outer surface of the spherical shape memory polymer particles or to be dispersed internally, making it unsuitable for application to the shape memory polymer composite particles.

The ratio of the average particle diameter of the ceramic powder to the average particle diameter of the spherical shape memory polymer particles may be 0.1 or more, 0.3 or more, 0.5 or more, 0.9 or less, 0.75 or less, 0.1 or more and 0.9 or less, 0.3 or more and 0.9 or less, 0.5 or more and 0.9 or less, 0.1 or more and 0.75 or less, 0.3 or more and 0.75 or less, or 0.5 or more and 0.75 or less.

The shape memory polymer composite particle may comprise the ceramic powder in an amount of 10 wt% or more and 80 wt% or less based on the total weight of the shape memory polymer composite particle.

Specifically, the shape memory polymer composite particle may comprise the ceramic powder in an amount of 10 wt% or more, 15 wt% or more, 16 wt% or more, 80 wt% or less, 70 wt% or less, 66 wt% or less, 10 wt% or more and 80 wt% or less, 15 wt% or more and 80 wt% or less, 16 wt% or more and 80 wt% or less, 10 wt% or more and 70 wt% or less, 15 wt% or more and 70 wt% or less, 16 wt% or more and 70 wt% or less, 10 wt% or more and 66 wt% or less, 15 wt% or more and 66 wt% or less, 16 wt% or more and 66 wt% or less based on the total weight of the shape memory polymer composite particle.

As the shape memory polymer composite particle comprises ceramic powder in the amount, in the composition for underfill comprising the shape memory polymer composite particles, a thermal path may be formed along the ceramic powder coated on the outer surface of the spherical shape memory polymer particle, or the ceramic powder may be included inside the spherical shape memory polymer particles, thereby increasing the thermal conductivity of the composite particles themselves.

If the content of the ceramic powder becomes excessively small, thermal conductivity may decrease, and if it becomes excessively large, the shape recovery ability of the shape memory polymer composite particles may deteriorate.

The composition for underfill may comprise the ceramic powder in an amount of 1 wt% or more and 30 wt% or less based on the total weight of the composition for underfill.

Specifically, the composition for underfill may comprise the ceramic powder in an amount of 1 wt% or more, 2 wt% or more, 30 wt% or less, 26 wt% or less, or 1 wt% or more and 30 wt% or less, 1 wt% or more and 26 wt% or less, 2 wt% or more and 30 wt% or less, or 2 wt% or more and 26 wt% or less based on the total weight of the composition for underfill.

As the composition for underfill comprises the ceramic powder in the amount, a thermal pathway may be formed along the ceramic powder coated on the outer surface of the spherical shape-memory polymer particle in the composition for underfill, or the ceramic powder may be included inside the spherical shape memory polymer particles, thereby increasing the thermal conductivity of the composite particles themselves.

If the content of the above ceramic powder becomes excessively small, the thermal conductivity may decrease, and if it becomes excessively large, the shape recovery ability of the shape memory polymer composite particle may be reduced.

The composition for underfill may comprise the shape memory polymer composite particle in an amount of 1 wt% or more and 70 wt% or less, based on the total weight of the composition for underfill.

Specifically, the composition for underfill may comprise the shape memory polymer composite particle in an amount of 1 wt% or more, 5 wt% or more, 10 wt% or more, 70 wt% or less, 60 wt% or less, 50 wt% or less, 45 wt% or less, 1 wt% or more and 70 wt% or less, 5 wt% or more and 70 wt% or less, 10 wt% or more and 70 wt% or less, 1 wt% or more and 60 wt% or less, 5 wt% or more and 60 wt% or less, 10 wt% or more and 60 wt% or less, 1 wt% or more and 50 wt% or less, 5 wt% or more and 50 wt% or less, 10 wt% or more and 50 wt% or less, 1 wt% or more and 45 wt% or less, 5 wt% or more and 45 wt% or less, or 10 wt% or more and 45 wt% or less, based on the total weight of the composition for underfill.

As the composition for underfill comprises the shape memory polymer composite particle in the amount, it is possible to simultaneously achieve excellent thermal conductivity and viscosity characteristics.

If the content of the shape memory polymer composite particles becomes excessively small, the distance between composite particles increases, reducing the contact between particles and making it difficult to form a heat transfer path, which may lower the thermal conductivity of the composition for underfill. In addition, if the content of the shape memory polymer composite particles becomes excessively large, the shape memory polymer composite particle acts as a flow resistance within the composition for underfill, causing a rapid increase in viscosity. Consequently, voids may form during the packaging process, or the filling time may become excessively long, resulting in poor processability.

Meanwhile, the shape memory polymer composite particle may include spherical shape memory polymer particle and ceramic powder bound to the spherical shape memory polymer particle; specifically, the shape memory polymer composite particle may include shape memory polymer composite particle in which the ceramic powder is dispersed inside the spherical shape memory polymer particle, or shape memory polymer composite particle in which a coating layer containing the ceramic powder is formed on the outer surface of the spherical shape memory polymer particle.

That is, in the shape memory polymer composite particles, the binding form of the ceramic powder may be that the ceramic powder is dispersed inside the spherical shape memory polymer particles, or that a coating layer is formed on the outer surface of the spherical shape memory polymer particle.

Specifically, the shape memory polymer composite particle dispersed inside the spherical shape memory polymer particles may be those in which the ceramic powder is dispersed inside the shape memory polymer particles through one or more processes selected from the group consisting of emulsification, spray drying, or microfluidics processes.

In addition, the shape memory polymer composite particle in which a coating layer containing the ceramic powder is formed on the outer surface of the spherical shape memory polymer may be those in which the ceramic powder is coated on the outer surface of the spherical shape memory polymer particles through one or more processes selected from the group consisting of mechanofusion, electrostatic attachment, van der Waals bonding, Pickering emulsion, or chemical bonding methods using a silane coupling agent.

The thermosetting resin may include one or more resins selected from the group consisting of epoxy resin, phenol resin, melamine resin, polyurethane resin, and polyester resin.

The curing agent may be appropriately selected depending on the type of shape memory polymer, and for example, the curing agent may include one or more selected from the group consisting of amine compounds such as 4,4'-diaminodiphenylmethane (DDM), 4,4'-methylenedianiline (MDA), triethylenetetramine (TETA), polyoxypropylenediamine, acid anhydride compounds such as phthalic anhydride, methyl nadic anhydride, HHPA (hexahydrophthalic anhydride), isocyanate compounds such as MDI (methylene diphenyl diisocyanate), TDI (toluene diisocyanate), HDI (hexamethylene diisocyanate), IPDI (isophorone diisocyanate), and divalent alcohol compounds such as BDO (1,4-butanediol) and ED (ethylene glycol).

The composition for underfill may additionally include a catalyst.

The catalyst acts as a curing catalyst, allowing control of the curing speed and ensuring high-temperature stability.

The catalyst is not particularly limited, but, for example, it may include at least one catalyst selected from the group consisting of catalysts for anhydride-based curing agents such as dimethylbenzylamine, tris(dimethylaminomethyl)phenol, and methylimidazole; catalysts for polyester such as cobalt naphthenate and dimethylaniline; and catalysts for polyurethane resins such as dibutyltin dilaurate and diazabicyclooctane.

The composition for underfill may have a viscosity of 100,000 cP or less.

Specifically, the viscosity may refer to the viscosity measured under ambient temperature and a shear rate of 10 s⁻¹ for the composition for underfill.

The method for measuring the viscosity is not particularly limited; for example, it may be measured using a rotational rheometer.

More specifically, the viscosity may refer to the value measured under the condition that the volume fraction of the shape memory polymer composite particles is 5 volume% or more and 60 volume% or less with respect to the total volume of the composition for underfill.

As the viscosity of the composition for underfill satisfies the range, it achieves low viscosity, which is advantageous for capillary flow during the filling stage, making it suitable for use in semiconductor packaging processes.

In addition, the composition for underfill may have a thermal conductivity of 0.5 W/m·K or more.

Specifically, the thermal conductivity refers to the value measured for a sample of the composition for underfill that has been thermally cured in a vacuum oven or hot air oven at atmospheric pressure, at 50°C to 100°C, for 10 hours or more and 15 hours or less. More specifically, the thermal conductivity refers to the value measured for a sample of the composition for underfill that has been cured in a vacuum oven or hot air oven at atmospheric pressure, at 80°C, for 12 hours.

The method for measuring the above thermal conductivity is not particularly limited; for example, after measuring the specific heat, density, and thermal diffusivity coefficient, the values can be multiplied to derive the thermal conductivity.

As the thermal conductivity of the composition for underfill satisfies the range, it may exhibit excellent thermal conductivity, effectively dissipating heat generated during operation in the package usage environment, and thus may be suitable for use in semiconductor packaging processes.

According to another embodiment of the disclosure, a method for manufacturing a composition for underfill, comprising the steps of: manufacturing a shape memory polymer composite particle; mixing and stirring a thermosetting resin, a curing agent, and the shape memory polymer composite particle; wherein the shape memory polymer composite particle comprise a spherical shape memory polymer particle and ceramic powder bonded to the spherical shape memory polymer particle may be provided

The contents regarding the shape memory polymer composite particle, thermosetting resin, curing agent, spherical shape memory polymer particle, and ceramic powder include all of the aforementioned details.

Specifically, in the method for manufacturing a composition for underfill according to the present disclosure, the step of manufacturing a shape memory polymer composite particle may include: a step of preparing a shape memory polymer composite particle precursor by combining spherical shape memory polymer particle and ceramic powder; a step of dispersing the shape memory polymer composite particle precursor in an water-soluble polymer solution and then drying to produce a water-soluble polymer film; a step of manufacturing a shape memory polymer composite particle by heating the water-soluble polymer film; and a step of dissolving the water-soluble polymer film in water to recover the shape memory polymer composite particle from the water-soluble polymer film.

The step of preparing a shape memory polymer composite particle precursor by combining spherical shape memory polymer particle and ceramic powder may include a step of dispersing the ceramic powder inside the shape memory polymer particle through one or more processes selected from a group consisting of emulsification, spray drying, or microfluidics processes; or a step of coating the ceramic powder on the outer surface of the spherical shape memory polymer particle through one or more processes selected from a group consisting of mechanofusion, electrostatic attachment, van der Waals bonding, Pickering emulsion, or chemical bonding methods using a silane coupling agent.

Combining the spherical shape memory polymer particle and the ceramic powder by the step of dispersing the ceramic powder inside the shape memory polymer particle through one or more processes selected from a group consisting of emulsification, spray drying, or microfluidics processes may produce a shape memory polymer composite particle in which the ceramic powder is dispersed inside the spherical shape memory polymer particle.

In addition, combining the spherical shape memory polymer particle and the ceramic powder by the step of coating the ceramic powder on the outer surface of the spherical shape memory polymer particle through one or more processes selected from a group consisting of mechanofusion, electrostatic attachment, van der Waals bonding, Pickering emulsion, or chemical bonding methods using a silane coupling agent may produce a shape memory polymer composite particle in which a coating layer comprising the ceramic powder is formed on the outer surface of the spherical shape memory polymer particle.

The step of dispersing the shape memory polymer composite particle precursor in an water-soluble polymer solution and then drying to produce an water-soluble polymer film may comprise the step of manufacturing a water-soluble polymer film by dispersing the shape memory polymer composite particle precursor in a water-soluble polymer solution, performing a first drying at room temperature for 20 hours or more and 30 hours or less, and subsequently performing a second drying in a vacuum oven or hot air oven at atmospheric pressure, at 50°C to 100°C, for 1 hour or more and 10 hours or less.

The water-soluble polymer is not particularly limited, but, for example, one or more polymers selected from the group consisting of polyvinyl alcohol, polyacrylic acid, polyethylene glycol, polyvinylpyrrolidone, and carboxymethyl cellulose may be used.

The step of manufacturing a shape memory polymer composite particle by heating the water-soluble polymer film may include: heating the water-soluble polymer film to at least the glass transition temperature of the shape memory polymer, and stretching to deform the shape memory polymer into a rod or plate shape; and thermally or photo-curing the water-soluble polymer film to permanently fix the precursor of the shape memory polymer composite particle inside the water-soluble polymer film in a high aspect ratio shape.

Specifically, the water-soluble polymer film may be stretched while heating it above the shape memory transition temperature (Ttrans), so that each individual shape memory polymer composite particle may have a permanent high aspect ratio shape with an aspect ratio of 2 or more.

In addition, after the stretching process, the shape memory polymer composite particle precursor may be cured through photopolymerization or thermal curing to have a permanent high aspect ratio shape.

The method for manufacturing the composition for underfill of the present disclosure may include the step of contracting the water-soluble polymer film at a temperature above the glass transition temperature of the composite particle, cooling it to a temperature below the glass transition temperature of the shape memory polymer to fix the shape memory polymer composite particle precursor inside the water-soluble polymer film in a spherical temporary shape after the step of thermally or photo-curing the water-soluble polymer film to permanently fix the precursor of the shape memory polymer composite particle inside the water-soluble polymer film in a high aspect ratio shape

The water-soluble polymer film may be contracted by removing the external force applied to the water-soluble polymer film at or above the shape memory transition temperature. In addition, as the temperature is cooled to room temperature, the shape memory polymer composite particle precursor inside the water-soluble polymer film may be fixed in a spherical temporary shape.

The method for manufacturing the composition for underfill of the present disclosure may include the step of dissolving the water-soluble polymer film in water to recover the shape memory polymer composite particles from the water-soluble polymer film.

Accordingly, the recovered shape memory polymer composite particles may be mixed with the thermosetting resin and curing agent to prepare a composition for underfill of the present disclosure.

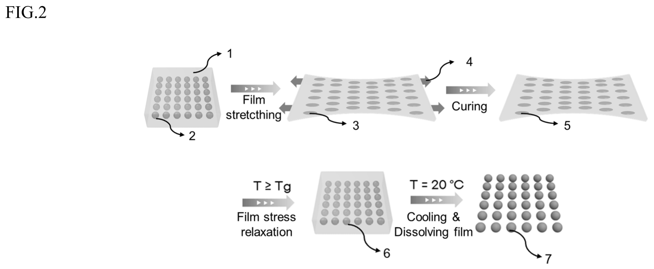

Specifically, a schematic diagram sequentially showing the entire process comprising the steps of dispersing the shape memory polymer composite particle precursor in a water-soluble polymer solution and drying to produce a water-soluble polymer film; manufacturing a shape memory polymer composite particle by heating the water-soluble polymer film; and dissolving the water-soluble polymer film in water to recover the shape memory polymer composite particles from the water-soluble polymer film is shown in Fig. 2. The shape memory polymer composite particle precursor (2) is dispersed in the water-soluble polymer film (1). The composite of the water-soluble polymer film (1) and the shape memory polymer composite particle precursor (2) is heated above the glass transition temperature of the shape memory polymer and then stretched by an external force (4), thereby deforming the shape memory polymer composite particle precursor (3) into a high aspect ratio shape. The stretched shape memory polymer composite particle precursor is then thermally or photo-cured to fix the high aspect ratio shape as the permanent shape of the shape memory polymer composite particle precursor (5). After removing the external force, the film is contracted above the glass transition temperature of the composite particles, and then cooled below the glass transition temperature, whereby the shape memory polymer composite particle precursor is inversely deformed into a spherical shape (6) and the temporary shape is fixed. The composite of the water-soluble polymer film (1) and the shape memory polymer composite particle precursor (2) is treated with water to dissolve and remove the water-soluble polymer film, and the shape memory polymer composite particles (7) with the temporary spherical shape fixed are recovered.

Although the embodiments of the present disclosure have been described in detail above, the scope of rights of the present disclosure is not limited thereto, and various modifications and improvements by those skilled in the art utilizing the basic concepts of the present disclosure as defined in the following claims also fall within the scope of rights of the present disclosure.

Hereinafter, the actions and effects of the disclosure will be explained in detail through specific examples. However, these examples are presented only as the illustrations of the invention, and the scope of the right of the invention is not limited thereby.

### Preparation Example: Preparation of Composite Particle

### Preparation Example 1

Spherical polymethyl methacrylate particles with an average particle size of 10 µm were used as a shape-memory polymer particle, and flake-shaped h-BN powder with an average particle size of 5 µm was used as ceramic particles.

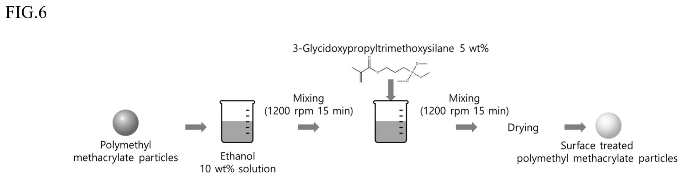

As shown in Figure 6, in order to functionalize the surface of the shape-memory polymer particles, spherical polymethyl methacrylate particles with an average particle size of 10 µm were stirred for 30 minutes in an ethanol solution containing 3 wt% 3-glycidoxypropyltrimethoxysilane, and then dried at 8°C for 5 hours to introduce silanol (Si-OH) functional groups onto the surface of the polymethyl methacrylate spherical particles.

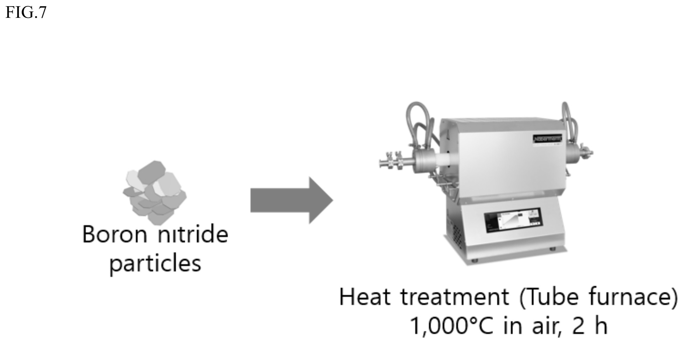

As shown in Figure 7, in order to activate the ceramic particles, flake-shaped h-BN powder with an average particle size of 5µm was heat-treated at 1000°C for 2 hours in an air atmosphere electric furnace, thereby introducing hydroxyl functional groups onto the surface.

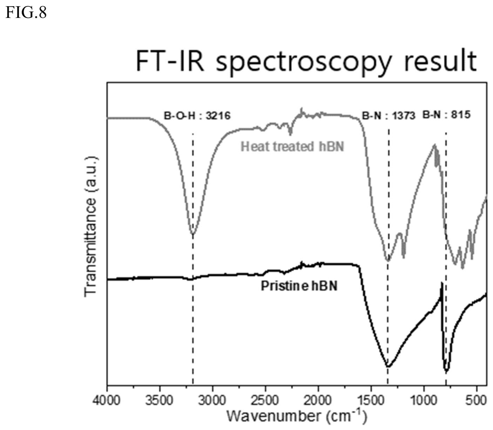

As shown in Figure 8, when Fourier transform infrared spectroscopy was performed on the heat-treated boron nitride, an absorption peak was observed at 3216 cm⁻¹, confirming that hydroxyl functional groups were introduced onto the surface of the boron nitride powder.

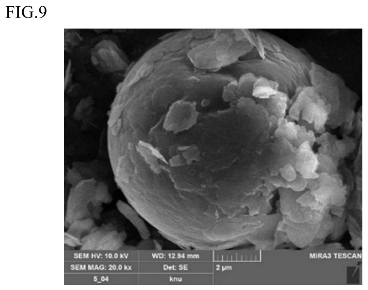

Spherical particles of polymethyl methacrylate with silanol (Si-OH) functional groups introduced on their surfaces and boron nitride powder with hydroxyl functional groups introduced on its surface were mixed in a stirrer for 30 minutes, producing a precursor of the composite particle of Figure 9 in which the ceramic powder is chemically bonded to the outer surface of the shape-memory polymer through a condensation reaction between the silanol and hydroxyl groups. The weight ratio of the polymethyl methacrylate spherical particles to the boron nitride powder in the precursor of the composite particle is 1 : 1.93.

1 g of the precursor of the composite particles was added to 66 g of a polyvinyl alcohol (Mowiol 4-88, Sigma-Aldrich, concentration: 20 wt%) solution and stirred to form a suspension.

The suspension was poured into a mold, and dried at room temperature to produce a polyvinyl alcohol film with a thickness of 0.35 mm and dimensions of 20 mm x 60 mm. The polyvinyl alcohol film was stretched using a universal testing machine (Instron 5969, Instron) at 150°C, then cooled to room temperature to permanently deform the film through the crystallization (cooling) of the precursor of the composite particles contained in the polyvinyl alcohol film, thereby producing composite particles with a permanent rod or plate shape.

At a temperature of 120 °C, which is above the glass transition temperature (105 °C) of the composite particles, the stress applied to the polyvinyl alcohol film was removed, and then, utilizing the shrinkage force of the polyvinyl alcohol matrix, the composite particles were deformed into a spherical shape and subsequently cooled to fix the temporary shape of the composite particles as spheres. Afterward, the polyvinyl alcohol film was placed in distilled water and dissolved using a vortex mixer (Vortex-Genie 2 mixer, Scientific Industries), and the particles were separated using a polyimide membrane filter with a vacuum flask. The permanent form of the finally produced composite particles was observed as rod or plate shapes, and the temporary shape was observed as spherical.

### Preparation Example 2

As the shape memory polymer particles, spherical cellulose acetate particle powder with an average particle size of 7 µm was used, and as the ceramic particles, flake-shaped h-BN powder with an average particle size of 5 µm was used.

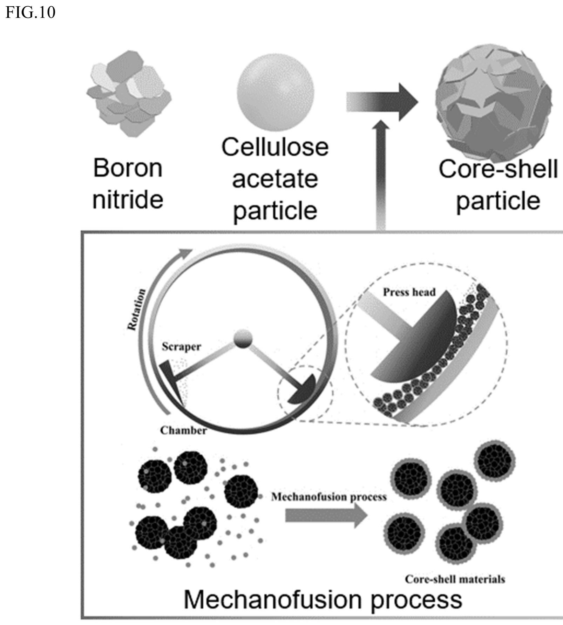

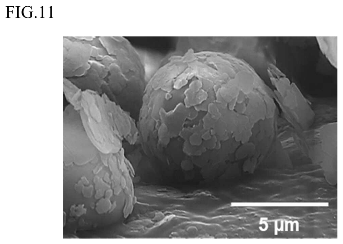

As shown in Figure 10, the dried spherical cellulose acetate particle powder with an average particle size of 7 µm and the flake-shaped h-BN powder with an average particle size of 5 µm were introduced into a mechanofusion chamber purged with argon gas at a mass ratio of 1:0.2. The mechanofusion equipment was operated at a rotation speed of 5000 rpm for 5 hours, thereby producing a composite particle precursor as shown in Figure 11, in which the ceramic powder was mechanically attached to the outer surface of the shape memory polymer by van der Waals bonding due to plastic deformation of the shape memory polymer particle surface caused by physical collision. The weight ratio of polymethyl methacrylate spherical particles and boron nitride powder in the precursor of the composite particles is 1:0.2.

1 g of the composite particle precursor was added to 66 g of a polyvinyl alcohol (Mowiol 4-88, Sigma-aldrich, concentration: 20 wt%) solution and stirred to form a suspension.

The suspension was poured into a mold and dried at room temperature to produce a polyvinyl alcohol film with a thickness of 0.35 mm and dimensions of 20 mm x 60 mm. The polyvinyl alcohol film was then stretched using a universal testing machine (Instron 5969, Instron) at 120°C, and the temperature was maintained for 30 minutes to rearrange the permanent shape due to the weakening of hydrogen bonding interactions of the cellulose acetate particles. Thereafter, the temperature was cooled to room temperature to permanently deform the composite particle precursor contained in the polyvinyl alcohol film by crystallization (cooling), thereby producing composite particles with a permanent rod or plate shape.

At a temperature of 90°C, which is higher than the glass transition temperature (80°C) of the above composite particles, the stress applied to the polyvinyl alcohol film was removed, and using the shrinkage force of the polyvinyl alcohol matrix, the composite particles were transformed into a spherical shape, then cooled to fix the temporary shape of the composite particles as spheres. Subsequently, the polyvinyl alcohol film was placed in distilled water and dissolved using a vortex mixer (Vortex-Genie 2 mixer, Sigma-Aldrich), and the particles were separated using a polyimide membrane filter with a vacuum flask. The permanently manufactured composite particles were observed to be rod-shaped or plate-shaped, and their temporary shape was observed to be spherical.

### Example: Preparation of Composition for underfill

The composite particles from the preparation example, a thermosetting resin (epoxy resin (bisphenol A diglycidyl ether), YD-115J, Kukdo Chemical), and a curing agent (polyetheramine, Jeffamine D-230, Sigma-Aldrich) were mixed in the weight ratios shown in Table 1 below. Using a planetary mixer (ARE-310, Thinkymixer), the mixture was stirred at 1000 rpm for 15 minutes (mixing mode), followed by 800 rpm for 5 minutes (defoaming mode) to carry out the stirring and defoaming processes. Subsequently, a vacuum pump was used to remove residual bubbles from the composition for underfill, thus preparing the composition for underfill.

### Comparative Example

A composition for underfill was prepared by mixing flake-shaped h-BN powder with an average particle size of 5 µm (density: 2.28 g/cm³), thermosetting resin (epoxy resin (bisphenol A diglycidyl ether), YD-115J, Kukdo Chemical), and curing agent (polyetheramine, Jeffamine D-230, Sigma-Aldrich) at the weight ratios shown in Table 1 below.

**[Table1]**

| | Type of Composite Particle | Composite Particle | h-BN powder | thermosetting resin | curing agent | Wt% of composite particle in the total underfill composition | Wt% of h-BN powder in the total underfill composition |
|---|---|---|---|---|---|---|---|
| | | (g) | (g) | (g) | (g) | | |
| Example1 | Preparation Example 1 | 1.73 | 0 | 8.23 | 2.57 | 13.81 | 9.1 |
| Example2 | Preparation Example 1 | 3.46 | 0 | 7.31 | 2.29 | 26.49 | 17.46 |
| Example3 | Preparation Example 1 | 5.19 | 0 | 6.4 | 2 | 38.19 | 25.17 |
| Example4 | Preparation Example 1 | 6.06 | 0 | 5.94 | 1.86 | 43.7 | 28.8 |
| Example5 | Preparation Example 2 | 1.29 | 0 | 8.3 | 2.59 | 10.61 | 2.34 |
| Example6 | Preparation Example 2 | 2.59 | 0 | 7.45 | 2.33 | 20.91 | 4.61 |
| Example7 | Preparation Example 2 | 3.88 | 0 | 6.61 | 2.06 | 30.91 | 6.81 |
| Example8 | Preparation Example 2 | 5.17 | 0 | 5.76 | 1.8 | 40.62 | 8.96 |
| Comparative Example 1 | - | 0 | 0.29 | 9.03 | 2.82 | 0 | 2.34 |
| Comparative Example 2 | - | 0 | 0.57 | 8.91 | 2.79 | 0 | 4.61 |
| Comparative Example 3 | - | 0 | 0.86 | 8.8 | 2.75 | 0 | 6.81 |
| Comparative Example 4 | - | 0 | 1.14 | 8.69 | 2.71 | 0 | 8.96 |
| Comparative Example 5 | - | 0 | 2.28 | 8.23 | 2.57 | 0 | 17.43 |
| Comparative Example 6 | - | 0 | 3.42 | 7.77 | 2.43 | 0 | 25.11 |

### <Experimental Example>

### 1. Observation of the Surface of Composite Particles

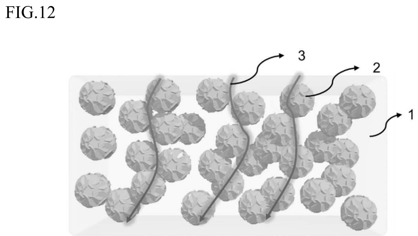

A schematic diagram showing a heat transfer path (3) along the ceramic on the outer surface of the shape memory polymer composite particles by dispersing shape memory polymer composite particles (2) of Preparation Example 2 in the composition for underfill (1) is shown in FIG. 12.

The composition for underfill of Example 5 was cast into a metal mold and thermally cured in a vacuum oven or hot air oven at atmospheric pressure and 80°C for 12 hours to produce a sample.

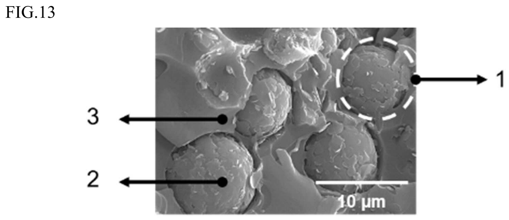

An image of the sample cured from the composition for underfill, observed with a scanning electron microscope, is shown in Figure 13. Within the cured sample, composite particles (1) with a core-shell structure, boron nitride particles (2) on the outer surface, and the cured resin matrix (3) were identified.

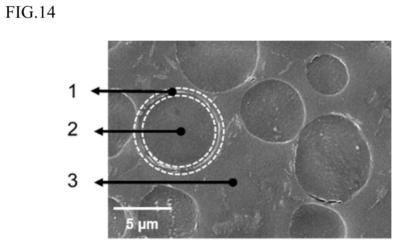

An image of the cross-section exposed by polishing the cured sample of the above composition for underfill and observed in two dimensions using a scanning electron microscope is shown in Figure 14. It was possible to identify the boron nitride particles (1) and the cured resin matrix (3) surrounding the composite particle (2) having a core-shell structure.

### 2. Physical Property Measurement

### 1) Thermal Conductivity

To measure the thermal conductivity of the composition for underfills of the examples and comparative examples, a Laser Flash Apparatus was used.

The composition for underfills of Examples 5-8 and Comparative Examples 1-4 were cast into a 40 mm x 40 mm x 5 mm metal mold and thermally cured in a vacuum oven or hot-air oven at atmospheric pressure at 80°C for 12 hours. After curing, specimens for thermal conductivity measurement were prepared by grinding and polishing.

For these specimens, the thermal diffusivity was measured using the Laser Flash Apparatus, the specific heat was measured using a differential scanning calorimeter (DSC), and the density was measured using a pycnometer.

Specifically, for thermal diffusivity and true density measurements, a disc-shaped specimen with a diameter of 12.7 mm and a thickness of 2.0 mm was used, and for specific heat measurement, a disc-shaped specimen with a diameter of 4.0 mm and a thickness of 1.0 mm was used.

Subsequently, the measured values of thermal diffusivity, density, and specific heat were multiplied to derive the thermal conductivity value.

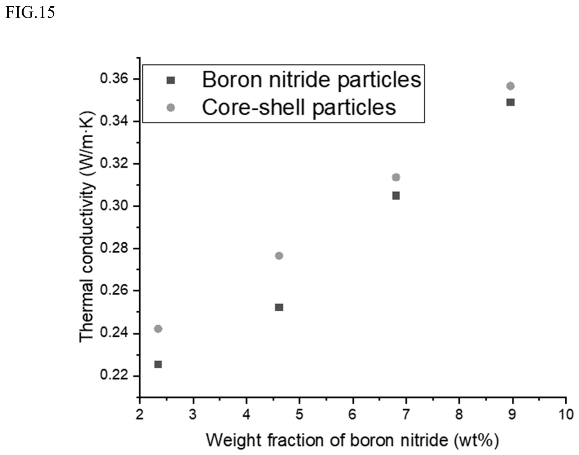

A graph comparing the thermal conductivity according to the weight ratio of boron nitride to the total weight of the composition for underfills of Examples 5-8 and Comparative Examples 1-4 is shown in FIG. 15.

It was confirmed that, due to the effect of improving thermal conductivity by the formation of a heat transfer path at the boron nitride volume fraction, the use of composite particles having a core-shell structure in the Examples resulted in higher thermal conductivity. Therefore, it was confirmed that, in order to improve thermal conductivity when manufacturing high thermal conductivity shape memory polymer composite particles, it is appropriate to coat ceramic particles on the external surface of the particles.

### 2) Viscosity

To analyze the difference in viscosity before and after the shape change, the viscosity of high aspect ratio boron nitride particles and shape memory polymer composite particles was measured. The viscosity was measured for the composition for underfills of Examples 5-8 and Comparative Examples 1-6 in an uncured liquid state using a rotational rheometer at room temperature and a shear rate of 10 s⁻¹.

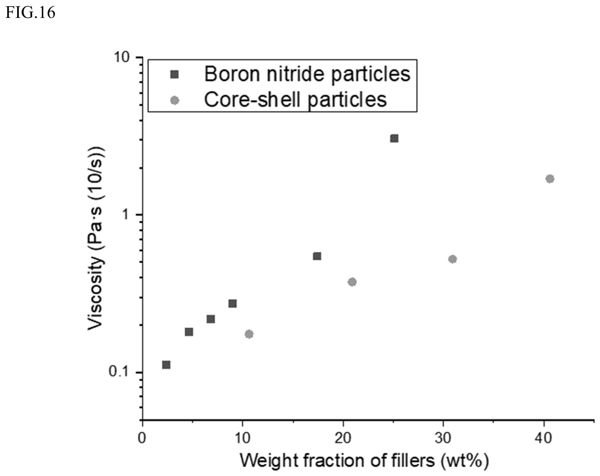

A graph comparing the viscosity according to the weight ratio of boron nitride to the total weight of the composition for underfills of Examples 5-8 and Comparative Examples 1-6 is shown in Figure 16.

As shown in Figure 16, particles with a high aspect ratio, such as the boron nitride particles of the comparative examples, exhibit a significant increase in viscosity even at low boron nitride particle weight ratios, whereas when using the spherical core-shell structured shape memory polymer composite particles of the examples, it was confirmed that the viscosity remained low even as the weight ratio of the shape memory polymer composite particles increased. Therefore, it is expected that a difference will occur before and after the shape change when shape memory polymer composite particles are applied, and it was confirmed that using the spherical core-shell structured shape memory polymer composite particles of the examples is advantageous for maintaining low viscosity.

## Claims

1. A composition for underfill, comprising a thermosetting resin, a curing agent, and a shape memory polymer composite particle, wherein the shape memory polymer composite particle comprise a spherical shape memory polymer particle and ceramic powder bonded to the spherical shape memory polymer particle.

2. The composition for underfill according to Claim 1, whein the shape memory polymer composite particle comprises the ceramic powder in an amount of 1 wt% or more and 60 wt% or less based on the total weight of the shape memory polymer composite particle.

3. The composition for underfill according to Claim 1, wherein the composition for underfill comprises the shape memory polymer composite particle in an amount of 1 wt% or more and 70 wt% or less, based on the total weight of the composition for underfill.

4. The composition for underfill according to Claim 1, wherein the spherical shape memory polymer particle have an average particle diameter of 0.1 µm or more and 50 µm or less.

5. The composition for underfill according to Claim 1, wherein the ceramic powder comprises one or more compounds selected from the group consisting of AlN, h-BN, Al₂O₃, and SiO₂.

6. The composition for underfill according to Claim 1, wherein the shape memory polymer composite particle comprises a shape memory polymer composite particle in which the ceramic powder is dispersed inside the spherical shape memory polymer particle, or a shape memory polymer composite particle in which a coating layer containing the ceramic powder is formed on the outer surface of the spherical shape memory polymer particle.

7. The composition for underfill according to Claim 6, wherein the shape memory polymer composite particle in which the ceramic powder is dispersed inside the spherical shape memory polymer particle is the shape memory polymer composite particle in which the ceramic powder is dispersed inside the shape memory polymer particles through one or more processes selected from the group consisting of emulsification, spray drying, or microfluidics processes.

8. The composition for underfill according to Claim 6, wherein the shape memory polymer composite particle in which a coating layer containing the ceramic powder is formed on the outer surface of the spherical shape memory polymer particle is the shape memory polymer composite particle in which the ceramic powder is coated on the outer surface of the spherical shape memory polymer particles through one or more processes selected from the group consisting of mechanofusion, electrostatic attachment, van der Waals bonding, Pickering emulsion, or chemical bonding methods using a silane coupling agent.

9. The composition for underfill according to Claim 1, wherein the composition for underfill have a viscosity of 100,000 cP or less

10. The composition for underfill according to Claim 1, wherein the composition for underfill have a thermal conductivity of 0.5 W/m·K or more.

11. A method for manufacturing a composition for underfill, comprising the steps of:
manufacturing a shape memory polymer composite particle;
mixing and stirring a thermosetting resin, a curing agent, and the shape memory polymer composite particle;
wherein the shape memory polymer composite particle comprise a spherical shape memory polymer particle and ceramic powder bonded to the spherical shape memory polymer particle

12. The method for manufacturing a composition for underfill according to Claim 11,
wherein the step of manufacturing a shape memory polymer composite particle comprises the steps of:
preparing a shape memory polymer composite particle precursor by combining spherical shape memory polymer particle and ceramic powder;
dispersing the shape memory polymer composite particle precursor in an water-soluble polymer solution and drying to produce a water-soluble polymer film;
manufacturing a shape memory polymer composite particle by heating the water-soluble polymer film; and
dissolving the water-soluble polymer film in water to recover the shape memory polymer.

13. The method for manufacturing a composition for underfill according to Claim 12,
wherein the step of manufacturing a shape memory polymer composite particle by heating the water-soluble polymer film comprises the step of:
heating the water-soluble polymer film to at least the glass transition temperature of the shape memory polymer, and stretching to deform the shape memory polymer into a rod or plate shape; and
thermally or photo-curing the water-soluble polymer film to permanently fix the precursor of the shape memory polymer composite particle inside the water-soluble polymer film in a high aspect ratio shape.

14. The method for manufacturing a composition for underfill according to Claim 13,
whrein comprises after the step of thermally or photo-curing the water-soluble polymer film to permanently fix the precursor of the shape memory polymer composite particle inside the water-soluble polymer film in a high aspect ratio shape,
the step of contracting the water-soluble polymer film at a temperature above the glass transition temperature of the composite particle, cooling it to a temperature below the glass transition temperature of the shape memory polymer to fix the shape memory polymer composite particle precursor inside the water-soluble polymer film in a spherical temporary shape.
